# EUROPEAN PATENT APPLICATION

(11) **EP 4 427 931 A1**
(43) Date of publication of application: **11.09.2024**
(21) Application number: 22889655.1
(22) Date of filing: 09.09.2022
(51) Int. Cl.: B32B 15/04, C25B 11/04, C25B 11/061, C25B 1/245

(54) **LAMINATE, AND ELECTRODE FOR ELECTROLYSIS**

(30) Priority: 04.11.2021 JP 2021180409
(71) Applicant: Resonac Corporation, Tokyo 105-7325 (JP); Kurita Seisakusho Co., Ltd., Tsuzukigun, Kyoto 610-0221 (JP)
(72) Inventor: TO Katsuaki, Tokyo 105-8518 (JP); OGURO Shinya, Tokyo 105-8518 (JP); FUKUCHI Yohsuke, Tokyo 105-8518 (JP); KOBAYASHI Hiroshi, Tokyo 105-8518 (JP); SUGIHARA Masahiko, Tsuzuki-gun, Kyoto 610-0221 (JP); YAMADA Yoji, Tsuzuki-gun, Kyoto 610-0221 (JP)
(74) Representative: Strehl Schübel-Hopf & Partner
(86) International application number: PCT/JP2022/033934
(87) International publication number: WO 2023/079831

(57) **Abstract**

There is provided a laminate having a base formed of nickel or a nickel alloy and a hard carbon coating film tightly adhering to the base and difficult to be peeled off. The laminate includes: a base (100) formed of nickel or a nickel alloy; an intermediate layer (200) formed on the base (100); and a hard carbon coating film (300) formed on the intermediate layer (200), in which the intermediate layer (200) contains nickel nitride.

## Description

### Technical Field

The present invention relates to a laminate and a method for producing the same. The present invention also relates to an electrode for electrolysis, a method for producing the same, and an electrolyzer. Further, the present invention relates to a gas production method for producing fluorine gas or nitrogen trifluoride.

### Background Art

Hard carbon materials typified by diamond-like carbon (hereinafter sometimes referred to as "DLC") have advantages of high hardness, high abrasion resistance, high chemical stability (corrosion resistance), high gas barrier properties, high seizure resistance, high biocompatibility, high infrared ray transmissibility, and a low friction coefficient. Therefore, for the purpose of imparting these properties, various bases are coated with a hard carbon coating film. For example, an electrode for electrolysis is known in which the surface of a base is coated with a DLC coating film (see PTL 1).

### Citation List

### Patent Literature

PTL 1: JP 2011-46994 A

### Summary of Invention

### Technical Problem

However, there has been a problem that it is difficult to make the hard carbon coating film tightly adhere to a base formed of nickel or a nickel alloy, and the hard carbon coating film is likely to be peeled off from the base. This point is described in detail.

A metal forming the base and the hard carbon coating film tightly adhere to each other due to a chemical interaction. The chemical interaction is a covalent bond formed by sharing electrons between atoms of the metal forming the base and atoms of carbon forming the hard carbon coating film.

A normal metal can form metal carbide, which is a compound in which the metal is covalently bonded to carbon. Therefore, a layer of the metal carbide is formed on the surface of the base, and the base and the hard carbon coating film tightly adhere to each other due to the chemical interaction through the metal carbide. Due to a joint through a chemical bond, the hard carbon coating film is difficult to be peeled off from the base.

However, nickel does not form metal carbide, and therefore the base and the hard carbon coating film are joined to each other only through a physical interaction. Therefore, the hard carbon coating film is likely to be peeled off from the base formed of nickel or a nickel alloy.

Therefore, an electrode for electrolysis in which the surface of the base formed of nickel or a nickel alloy is coated with the DLC coating film has been prone to peeling of the DLC coating film, and the life has been likely to be shortened. The nickel and the nickel alloy are suitable as the base of the electrode for electrolysis due to the high corrosion resistance thereof. Therefore, it has been desired to develop a technique of making the hard carbon coating film tightly adhere to the surface of the base formed of nickel or a nickel alloy.

It is an object of the present invention to provide a laminate having a base formed of nickel or a nickel alloy and a hard carbon coating film tightly adhering to the base and difficult to be peeled off, and a method for producing the same. It is another object of the present invention to provide an electrode for electrolysis in which the hard carbon coating film is difficult to be peeled off from the base formed of nickel or a nickel alloy, a method for producing the same, an electrolyzer, and a gas production method.

### Solution to Problem

To achieve the above-described objects, one aspect of the present invention is as described in [1] to [12] below.
[1] A laminate including: a base formed of nickel or a nickel alloy; an intermediate layer formed on the base; and a hard carbon coating film formed on the intermediate layer, in which the intermediate layer contains nickel nitride.
[2] The laminate according to [1], in which the nickel alloy is an alloy containing the nickel in a proportion of 50% by mass or more.
[3] The laminate according to [1] or [2], in which the nickel nitride is at least one of Ni₄N and Ni₃N.
[4] The laminate according to any one of [1] to [3], in which the hard carbon coating film is formed of diamond-like carbon.
[5] A method for producing a laminate, the laminate being the laminate according to any one of [1] to [4], the method including: an intermediate layer forming step of forming the intermediate layer by nitriding nickel of a surface layer part of the base using nitrogen gas plasma.
[6] The method for producing a laminate according to [5], in which the intermediate layer forming step is a step of repeating applying a high frequency pulse from a high frequency power supply for plasma generation and applying a negative high voltage pulse from a power supply for high voltage pulse generation, to the base in a nitrogen gas atmosphere.
[7] An electrode for electrolysis including the laminate according to any one of [1] to [4].
[8] The electrode for electrolysis according to [7], the electrode is used for synthesizing a fluorine-containing compound by electrolyzing a molten salt containing a fluoride ion.
[9] The electrode for electrolysis according to [7], the electrode is used for synthesizing fluorine gas or nitrogen trifluoride by electrolyzing a molten salt containing hydrogen fluoride.
[10] A method for producing an electrode for electrolysis, the electrode for electrolysis being the electrode for electrolysis according to any one of [7] to [9], the method including: an intermediate layer forming step of forming the intermediate layer by nitriding nickel of a surface layer part of the base using nitrogen gas plasma.
[11] An electrolyzer, including: the electrode for electrolysis according to any one of [7] to [9].
[12] A gas production method for producing fluorine gas or nitrogen trifluoride including: synthesizing fluorine gas or nitrogen trifluoride by electrolyzing a molten salt containing hydrogen fluoride using the electrode for electrolysis according to [7].

### Advantageous Effects of Invention

The present invention can provide a laminate having a base formed of nickel or a nickel alloy and a hard carbon coating film tightly adhering to the base and difficult to be peeled off and a method for producing the same. Further, the present invention can provide an electrode for electrolysis in which a hard carbon coating film is difficult to be peeled off from a base formed of nickel or a nickel alloy, a method for producing the same, an electrolyzer, and a gas production method.

### Brief Description of Drawings

FIG. 1 is a cross-sectional view illustrating the configuration of a laminate according to one embodiment of the present invention;

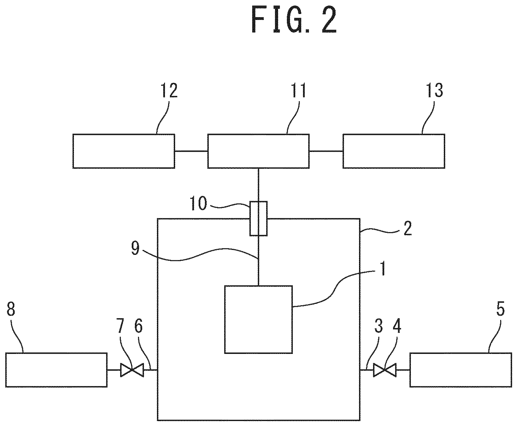

FIG. 2 is a schematic diagram illustrating the configuration of a film forming apparatus used in Examples and Comparative Examples;
FIG. 3 is a measurement chart illustrating the results of analyzing the surface of a laminate of Example 1 under the condition of an accelerating voltage of 5 kV using a scanning electron microscope-energy dispersive X-ray analyzer;
FIG. 4 is a measurement chart illustrating the results of analyzing the surface of the laminate of Example 1 under the condition of an accelerating voltage of 15 kV using a scanning electron microscope-energy dispersive X-ray analyzer; and
FIG. 5 is a measurement chart illustrating the results of analyzing the surface of the laminate of Example 1 using an X-ray diffraction device.

### Description of Embodiments

Hereinafter, one embodiment of the present invention is described. This embodiment illustrates one example of the present invention, and the present invention is not limited to this embodiment. This embodiment can be variously altered or improved, and such altered or improved aspects may also be included in the present invention.

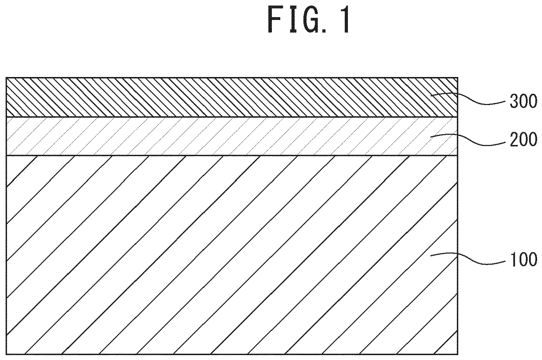

As illustrated in FIG. 1, a laminate according to this embodiment includes a base 100 formed of nickel (Ni) or a nickel alloy, an intermediate layer 200 formed on the base 100, and a hard carbon coating film 300 formed on the intermediate layer 200. The intermediate layer 200 contains nickel nitride.

In the laminate according to this embodiment, the intermediate layer 200 containing nickel nitride is formed between the base 100 formed of nickel or a nickel alloy and the hard carbon coating film 300, which allows the base 100 and the hard carbon coating film 300 to have a chemical interaction through the intermediate layer 200. Therefore, the base 100 and the hard carbon coating film 300 tightly adhere to each other, and the hard carbon coating film 300 is difficult to be peeled off from the base 100.

The laminate according to this embodiment includes the hard carbon coating film 300, and therefore is imparted with properties, such as high hardness, high abrasion resistance, high chemical stability (high corrosion resistance), high gas barrier properties, high seizure resistance, high biocompatibility, high infrared ray transmissibility, and a low friction coefficient possessed by a hard carbon material. Since the hard carbon coating film 300 is difficult to be peeled off, these properties are likely to be maintained over a long period of time.

In the laminate according to this embodiment, an alloy containing nickel in a proportion of 50% by mass or more is usable as the nickel alloy. Metals other than nickel contained in the nickel alloy include iron, copper, chromium, molybdenum, and the like. In the case of conventional technologies, when the content of nickel in the nickel alloy is smaller, the base and the hard carbon coating film are more likely to adhere to each other, and when the content of nickel in the nickel alloy is larger, the adhesion between the base and the hard carbon coating film decreases. However, in the case of the laminate according to this embodiment, the intermediate layer 200 is formed between the base 100 and the hard carbon coating film 300, and therefore, even when the content of nickel in the nickel alloy is 50% by mass or more, the base 100 and the hard carbon coating film 300 tightly adhere to each other. In the laminate according to this embodiment, an alloy containing nickel in the proportion of 65% by mass or more is also usable as the nickel alloy.

The type of the nickel nitride contained in the intermediate layer 200 is not particularly limited, and is preferably at least one of Ni₄N and Ni₃N. With such a configuration, the base 100 and the hard carbon coating film 300 can be made to more tightly adhere to each other. The intermediate layer 200 may be formed of only nickel nitride or may be formed of a mixture of nickel nitride and the other materials.

The type of the hard carbon material forming the hard carbon coating film 300 is not particularly limited, and is preferably diamond-like carbon. The diamond-like carbon can impart the various excellent properties described above to the laminate, and can easily form a coating film on the surface of the base 100 formed of nickel or a nickel alloy.

When the laminate according to this embodiment is produced, the intermediate layer 200 is first formed on the base 100 (intermediate layer forming step), and then the hard carbon coating film 300 is formed on the intermediate layer 200 (hard carbon coating film forming step). In the intermediate layer forming step, the intermediate layer 200 is formed by nitriding nickel of the surface layer part of the base 100 using nitrogen gas plasma.

When the intermediate layer forming step is carried out, the surface of the base 100 may be cleaned before the formation of the intermediate layer 200. A cleaning method includes, but not particularly limited to: a method for ultrasonically cleaning the intermediate layer 200 while the intermediate layer 200 is immersed in alcohol, acid, or alkali; a method for cleaning the intermediate layer 200 by wiping the surface with paper, cloth, or the like; a method for cleaning the intermediate layer 200 by rubbing the surface with a brush or the like; and a method for cleaning the intermediate layer 200 using plasma, for example.

In the intermediate layer forming step, nitrogen gas plasma is generated near the base 100 to thereby nitride nickel of the surface layer part of the base 100, so that the intermediate layer 200 containing nickel nitride can be formed. For example, the base 100 is installed in a treatment chamber (hereinafter sometimes referred to as a "chamber"), gas in the chamber is exhausted to bring the inside of the chamber into a vacuum state, and then nitrogen gas is introduced as raw material gas of the nitrogen gas plasma into the chamber. Then, applying a high frequency pulse from a high frequency power supply for plasma generation 12 and applying a negative high voltage pulse from a power supply for high voltage pulse generation 13 to the base 100 itself in a nitrogen gas atmosphere are repeated, thereby nitriding nickel of the surface layer part of the base 100, so that the intermediate layer 200 can be formed.

The frequency of the high frequency pulse can be set to any frequency in the range of 10 MHz or more and 50 MHz or less, and can be set to 13.56 MHz, for example. The voltage of the high voltage pulse can be set to any voltage in the range of -1 V or more and -30 kV or less. It can be determined from an XRD spectrum obtained by X-ray diffraction analysis, for example, whether the intermediate layer 200 is successfully formed.

The surface roughness of the base 100 is not particularly limited, and the arithmetic mean roughness Ra is preferably set to 1 um or less and more preferably set to 0.5 um or less. When the arithmetic mean roughness Ra is 1 um or less, the continuity of the hard carbon coating film 300 is less likely to be interrupted by irregularities on the surface of the base 100 when the hard carbon coating film 300 is formed, and defects are less likely to occur in the hard carbon coating film 300.

The method for forming the hard carbon coating film 300 on the intermediate layer 200 is not particularly limited insofar as a coating film containing the hard carbon materials can be formed, and common dry film-forming methods are usable. The film forming methods include vacuum evaporation methods (e.g., a resistance heating evaporation method, an electron beam evaporation method), a sputtering method, an ion plating method, a hot filament CVD method, a plasma CVD method, a microwave plasma CVD method, and a plasma arc jet CVD method, for example.

The use of the laminate according to this embodiment as an electrode for electrolysis described later requires imparting electrical conductivity to the hard carbon coating film 300. Herein, "having electrical conductivity" in the present invention means that the electrical resistivity is 0.1 Ω·m or less. Thus, the hard carbon coating film forming step is required to be carried out as described below. One example is described.

For example, when the hard carbon coating film 300 is formed by a plasma CVD method using hydrocarbon gas, the temperature of the base 100 in the film formation is set to 250°C or more and 700°C or less. This can set hydrogen atoms contained in the hard carbon coating film 300 to less than 15% by atom, and therefore the hard carbon coating film 300 having electrical conductivity can be formed.

The hard carbon coating film formed by usual methods contains hydrogen atoms in a proportion of 15 to 30% by atom and has an electrical resistance close to that of an insulator, and therefore requires the addition of a dopant element. However, the hard carbon coating film 300 formed by the above-described method has the electrical conductivity even without adding a dopant, and therefore the addition of a dopant may or may not be performed.

Although film forming methods other than the plasma CVD method can also be selected, film forming methods that can be carried out at a process temperature of 1000°C or less are preferable, and film forming methods that can be carried out at a process temperature of 900°C or less are more preferable. When film forming methods having a process temperature more than 1000°C are selected, nickel itself may sublimate. Any film forming method is usable insofar as the above-described process temperature is satisfied and the electrical conductivity can be imparted. For example, the film forming method includes film forming methods, such as the vacuum evaporation method, described above.

The laminate according to this embodiment described above is suitable as a member constituting an electrode for electrolysis (particularly an anode) because the laminate has the above-described various properties, such as abrasion resistance and chemical stability, in addition to the fact that the laminate has the base 100 and the hard carbon coating film 300 tightly adhering to each other and that the hard carbon coating film 300 is difficult to be peeled off from the base 100. The hard carbon coating film 300 is difficult to be peeled off, which prolongs the life of the electrode for electrolysis containing the laminate according to this embodiment.

In particular, an electrode for electrolysis used for synthesizing a fluorine-containing compound by electrolyzing a molten salt containing fluoride ions, e.g., an electrode for electrolysis used for synthesizing fluorine gas (F₂) or nitrogen trifluoride (NF₃) by electrolyzing a molten salt containing hydrogen fluoride (HF), is required to have excellent corrosion resistance. Therefore, the electrode for electrolysis containing the laminate according to this embodiment is suitable for these applications.

When an electrolyzer is constituted using the above-described electrode for electrolysis, the electrolyzer can be imparted with a long life. The electrolyzer including the above-described electrode for electrolysis can synthesize various compounds by electrolyzing an electrolyte. For example, a fluorine-containing compound can be synthesized by electrolyzing a molten salt containing fluoride ions. Specifically, fluorine gas or nitrogen trifluoride can be synthesized by electrolyzing a molten salt containing hydrogen fluoride.

The electrolyzer has an electrolytic cell housing an electrolyte inside, an anode arranged inside the electrolytic cell to be immersed in the electrolyte, and a cathode arranged inside the electrolytic cell to be immersed in the electrolyte and arranged facing the anode. The inside of the electrolytic cell is divided into an anode chamber and a cathode chamber by a partition member, such as a vertically extending partition wall. The anode is arranged in the anode chamber and the cathode is arranged in the cathode chamber, and therefore the partition member prevents the mixing of fluorine gas or a fluorine-containing compound generated at the anode with hydrogen gas (H₂) generated at the cathode.

Materials of the electrolytic cell are not particularly limited. From the viewpoint of corrosion resistance, copper, soft steel, a nickel alloy, such as Monel (registered trademark), fluororesin, and the like are preferably used.

The shapes of the anode and the cathode are not particularly limited, and a plate shape, a punched plate shape, and the like can be freely selected.

Next, examples of the electrolyte are described. When fluorine gas is electrolytically synthesized, a mixed molten salt of hydrogen fluoride and potassium fluoride (KF), a mixed molten salt of hydrogen fluoride and cesium fluoride (CsF), and a mixed molten salt of hydrogen fluoride, potassium fluoride, and cesium fluoride are usable as the electrolyte.

The molar ratio of the hydrogen fluoride and the potassium fluoride in the mixed molten salt of the hydrogen fluoride and the potassium fluoride can be set to Hydrogen fluoride:Potassium fluoride = 1.5 to 2.5:1. The molar ratio of the hydrogen fluoride and the cesium fluoride in the mixed molten salt of the hydrogen fluoride and the cesium fluoride can be set to Hydrogen fluoride:Cesium fluoride = 1.0 to 4.0:1. The molar ratio of the hydrogen fluoride, the potassium fluoride, and the cesium fluoride in the mixed molten salt of the hydrogen fluoride, the potassium fluoride, and the cesium fluoride can be set to Hydrogen fluoride:Potassium fluoride:Cesium fluoride = 1.5 to 4.0:0.01 to 1.0:1.

When nitrogen trifluoride is electrolytically synthesized, a mixed molten salt of hydrogen fluoride and ammonium fluoride (NH₄F) is usable as the electrolyte. The molar ratio of the hydrogen fluoride and the ammonium fluoride in the mixed molten salt of the hydrogen fluoride and the ammonium fluoride can be set to Hydrogen fluoride:Ammonium fluoride = 1.5 to 2.5:1.

In the above-described electrolyzer, the above-described electrode for electrolysis is used as the anode and an electrode formed of a metal material, such as iron, copper, or nickel, is used as the cathode, and a current with a current density of 0.01 A/cm² or more and 5 A/cm² or less, for example, is supplied between the anode and the cathode to electrolyze the above-described electrolyte, so that fluorine gas or nitrogen trifluoride is generated at the anode and hydrogen gas is generated at the cathode. By electrolyzing one obtained by adding an organic substance to the above-described electrolyte or by electrolyzing an organic substance itself as the electrolyte, a fluorine-containing compound other than nitrogen trifluoride can also be obtained.

When a mixed molten salt of hydrogen fluoride and potassium fluoride is electrolyzed using an electrode for electrolysis not including the intermediate layer containing nickel nitride, i.e., an electrode for electrolysis in which the surface of the base formed of nickel or a nickel alloy is coated with a DLC coating film, the peeling of the DLC coating film occurs due to the generation of gas immediately after the start of the electrolysis. In contrast thereto, the electrode for electrolysis according to this embodiment has the intermediate layer 200 containing nickel nitride. Therefore, even when the electrolysis of the mixed molten salt of hydrogen fluoride and potassium fluoride is continued over a long period of time, the peeling of the hard carbon coating film 300 does not occur and the use can be continued until the function as an electrode is lost.

### EXAMPLES

Hereinafter, the present invention is more specifically described with reference to Examples and Comparative Examples.

### [Example 1]

First, a film forming apparatus used for the nitriding treatment and the formation of the hard carbon coating film is described with reference to FIG. 1.

The film forming apparatus in FIG. 1 includes: a chamber 2 housing an object to be treated 1; a gas supply device 5 supplying gas to the chamber 2; a gas supply pipe 3 connecting the chamber 2 and the gas supply device 5; a gas introduction valve 4 provided in the gas supply pipe 3; an evacuator 8 reducing the pressure inside the chamber 2; an exhaust pipe 6 connecting the chamber 2 and the evacuator 8; an exhaust valve 7 provided in the exhaust pipe 6; a current introduction terminal (high voltage feedthrough) 10 attached to the chamber 2 and connected to the object to be treated 1 through a conductor 9; a superimposing device 11 connected to an upper part of the current introduction terminal 10; and the high frequency power supply for plasma generation 12 and the power supply for high voltage pulse generation 13, which are connected to the superimposing device 11. The gas supply device 5 separately stores various types of gases required for the nitriding treatment of the object to be treated 1 and the formation of the hard carbon coating film.

Next, a method for the nitriding treatment and a method for forming the hard carbon coating film are described. As the object to be treated 1 equivalent to the base of the laminate, a plate (size: 20 mm × 10 mm × 1 mm) formed of Monel (registered trademark) 400, which is a nickel alloy containing 65% by mass of nickel, 33% by mass of copper, and 2% by mass of iron, was used. The base was placed as the object to be treated 1 in the chamber 2, and the evacuator 8 was activated to bring the inside of the chamber 2 into a high vacuum state. Then, a mixed gas of 10% by volume of argon and 90% by volume of hydrogen gas was introduced into the chamber 2 from the gas supply device 5 gas through the gas supply pipe 3.

Subsequently, an operation of applying a high frequency pulse with a pulse width of 50 us and a frequency of 13.56 MHz to the base and, during the period from immediately after the application until 100 us was reached, applying a high voltage pulse with a pulse width of 5 µs at a voltage of -5 kV once to the base was repeated at about 4000 times/second, and this repeated operation was performed for 30 minutes, thereby cleaning the surface of the base.

Next, nitrogen gas was introduced into the chamber 2 from the gas supply device 5 through the gas supply pipe 3 while the vacuum degree in the chamber 2 was maintained at 1.5 Pa. Subsequently, an operation of applying a high frequency pulse with a pulse width of 50 us and a frequency of 13.56 MHz to the base to generate plasma and, during the period from immediately after the application until 100 us was reached, applying a high voltage pulse with a pulse width of 4 us at a voltage of -20 kV once to the base was repeated at about 4000 times/second, and this repeated operation was performed for 160 minutes, thereby nitriding the surface of the base.

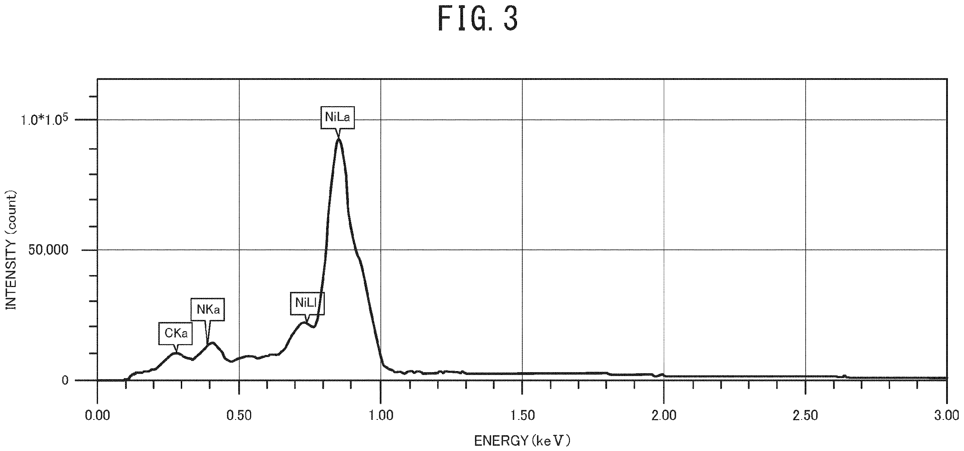

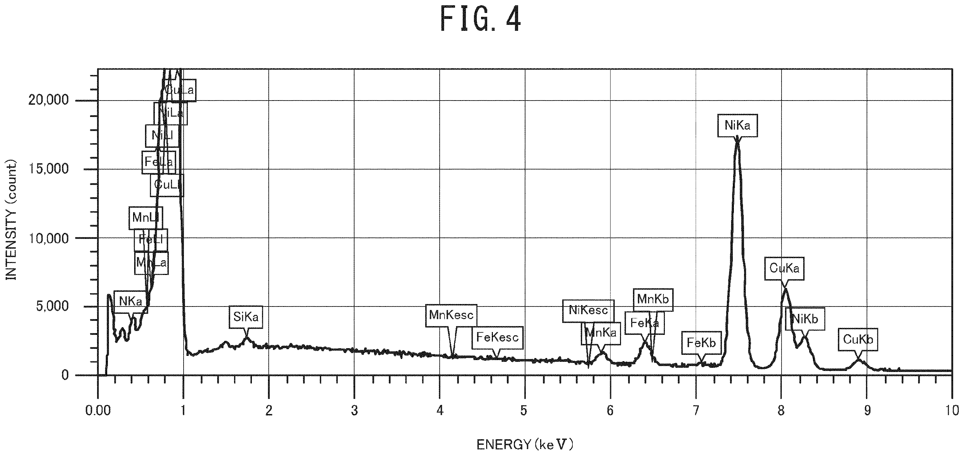

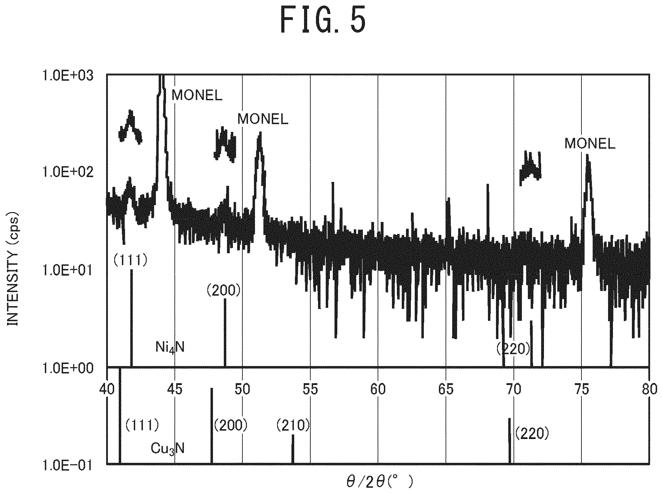

Herein, a surface analysis of the base subjected to the nitriding treatment was performed to confirm whether the surface was nitrided. FIGS. 3 and 4 illustrate measurement charts obtained by analyzing the surface of the base using a scanning electron microscope-energy dispersive X-ray analyzer. FIG. 3 is a measurement chart obtained by performing the analysis under the condition of an accelerating voltage of 5 kV. FIG. 4 illustrates a measurement chart obtained by performing the analysis under the condition of an accelerating voltage of 15 kV. FIG. 5 illustrates a measurement chart obtained by analyzing the surface of the base using an X-ray diffraction device. An angle ω formed by an incident X-ray and the crystal surface of a sample is 5°.

The nitrogen peak is observed in the measurement chart in FIG. 3, which shows that nitride is formed on the surface of the base. Further, the peaks of nickel, copper, and iron, which are the components of the Monel (registered trademark) 400, are observed in the measurement chart in FIG. 4, and therefore it is assumed that nitride is formed on the outermost surface of the base. Further, peaks indicating the lattice constants (111), (200), and (220) of Ni₄N are observed in the measurement chart in FIG. 5, which shows that nickel nitride Ni₄N is formed on the surface of the base.

Next, acetylene gas was introduced into the chamber 2 from the gas supply device 5 through the gas supply pipe 3 while the vacuum degree in the chamber 2 was maintained at 0.75 Pa. Subsequently, an operation of applying a high frequency pulse with a pulse width of 50 us and a frequency of 13.56 MHz to the base subjected to the nitriding treatment and, during the period from immediately after the application until 100 us was reached, applying a high voltage pulse with a pulse width of 5 µs at a voltage of -20 kV once to the base was repeated at about 4000 times/second. This repeated operation was performed for 30 minutes, thereby forming the DLC coating film on the surface of the base having the nitrided surface to give a laminate. By the repeated operation, the temperature of the base became 250°C or more and 700°C or less.

By subjecting the laminate to a scratch test to measure the critical load, the adhesion of the DLC coating film was evaluated. The scratch test was performed using an ultra-thin film scratch tester CSR 5000 manufactured by RHESCA CO., LTD. The scratch test was performed using a method according to an adhesion test for thin films containing a glass as a substrate specified in JIS R3225, and the scratch rate was set to 10 um/sec. As a result, the critical load was 37.6 mN, which showed that the base formed of a nickel alloy and the DLC coating film tightly adhered to each other.

Next, the laminate was processed to produce an electrode for electrolysis. More specifically, for a partial region (a square region measuring 1 cm long and 1 cm wide) of the surface of the laminate, the intermediate layer formed of nickel nitride and the DLC coating film were peeled off to expose the surface of the base, and the exposed part was connected to a power supply circuit to form an anode. Only a non-exposed part of this anode was immersed in an electrolyte, and the electrolyte was electrolyzed using a nickel plate as a cathode. As the electrolyte, a mixed molten salt (KF·2HF) of hydrogen fluoride and potassium fluoride was used and a current density was set to 0.4 A/cm², and a constant current electrolysis was performed.

The electrolysis was continued for 3000 Ahr, but the fluorine gas generation current efficiency was 95%, and the electrolytic voltage was approximately 6 V and did not change. The anode was taken out after the end of the electrolysis, and the mass was measured. There was no change in the mass before and after electrolysis, and the peeling of the DLC coating film on the surface was not observed.

### [Comparative Example 1]

A laminate in which the surface of the base was coated with the DLC coating film was obtained in the same manner as in Example 1, except that the cleaning described below was performed in place of the nitriding treatment. Argon was introduced into the chamber 2 from the gas supply device 5 through the gas supply pipe 3 while the vacuum degree in the chamber 2 was maintained at 1.5 Pa. Subsequently, an operation of applying a high frequency pulse with a pulse width of 50 us and a frequency of 13.56 MHz to the base and, during the period from immediately after the application until 100 us was reached, applying a high voltage pulse with a pulse width of 4 us at a voltage of -20 kV once to the base was repeated at about 4000 times/second, and this repeated operation was performed for 160 minutes, thereby cleaning the surface of the base.

By subjecting the laminate of Comparative Example 1 to a scratch test to measure the critical load in the same manner as in Example 1, the adhesion of the DLC coating film was evaluated. As a result, the critical load was 8.5 mN, which showed that the intermediate layer containing nickel nitride was not formed, and therefore the adhesion between the base formed of a nickel alloy and the DLC coating film was insufficient.

Next, the laminate of Comparative Example 1 was processed in the same manner as in Example 1 to produce an electrode for electrolysis. Then, the electrode for electrolysis was used as an anode to electrolyze an electrolyte in the same manner as in Example 1. The voltage, which was 6 V at the start of the electrolysis, increased to 10 V when the electrolysis was continued for 200 Ahr. When the anode was taken out and observed, the DLC coating film on the surface of the electrode was peeled off and disappeared.

### [Example 2]

A laminate was obtained in the same manner as in Example 1, except that the material of the base was changed from Monel (registered trademark) 400 to nickel.

By subjecting the laminate of Example 2 to a scratch test to measure the critical load in the same manner as in Example 1, the adhesion of the DLC coating film was evaluated. As a result, it was found that the critical load was 60.1 mN and that the base formed of nickel and the DLC coating film tightly adhered to each other.

Next, the laminate of Example 2 was processed in the same manner as in Example 1 to produce an electrode for electrolysis. Then, the electrode for electrolysis was used as an anode to electrolyze an electrolyte in the same manner as in Example 1.

The electrolysis was continued for 3000 Ahr, but the fluorine gas generation current efficiency was 95%, and the electrolytic voltage was approximately 6 V and did not change. The anode was taken out after the end of the electrolysis, and the mass was measured. There was no change in the mass before and after electrolysis, and the peeling of the DLC coating film on the surface was not observed.

### [Example 3]

A laminate was obtained in the same manner as in Example 1, except that the material of the base was changed from Monel (registered trademark) 400 to Hastelloy (registered trademark) C22. The Hastelloy (registered trademark) C22 is a nickel alloy containing 56% by mass of nickel, and contains, as metals other than nickel, 22% by mass of chromium and 13% by mass of molybdenum, for example.

By subjecting the laminate of Example 3 to a scratch test to measure the critical load in the same manner as in Example 1, the adhesion of the DLC coating film was evaluated. As a result, it was found that the critical load was 56.5 mN and that the base formed of the Hastelloy (registered trademark) C22 and the DLC coating film tightly adhered to each other.

### [Comparative Example 2]

A laminate was obtained in the same manner as in Comparative Example 1, except that the material of the base was changed from Monel (registered trademark) 400 to nickel.

By subjecting the laminate of Comparative Example 2 to a scratch test to measure the critical load in the same manner as in Example 1, the adhesion of the DLC coating film was evaluated. As a result, it was found that the critical load was 7.2 mN and that the intermediate layer containing nickel nitride was not formed, and therefore the adhesion between the base formed of nickel and the DLC coating was insufficient.

Next, the laminate of Comparative Example 2 was processed in the same manner as in Example 1 to produce an electrode for electrolysis. Then, the electrode for electrolysis was used as an anode to electrolyze an electrolyte in the same manner as in Example 1. The voltage, which was 6 V at the start of the electrolysis, increased to 10 V when the electrolysis was continued for 300 Ahr. When the anode was taken out and observed, the DLC coating film on the surface of the electrode was peeled off and disappeared.

### Reference Signs List

- 100: base
- 200: intermediate layer
- 300: hard carbon coating film

## Claims

1. A laminate comprising:
a base formed of nickel or a nickel alloy;
an intermediate layer formed on the base; and
a hard carbon coating film formed on the intermediate layer, wherein
the intermediate layer contains nickel nitride.

2. The laminate according to claim 1, wherein the nickel alloy is an alloy containing the nickel in a proportion of 50% by mass or more.

3. The laminate according to claim 1 or 2,
wherein the nickel nitride is at least one of Ni₄N and Ni₃N.

4. The laminate according to any one of claims 1 to 3, wherein the hard carbon coating film is formed of diamond-like carbon.

5. A method for producing a laminate,
the laminate being the laminate according to any one of claims 1 to 4,
the method comprising:
an intermediate layer forming step of forming the intermediate layer by nitriding nickel of a surface layer part of the base using nitrogen gas plasma.

6. The method for producing a laminate according to claim 5, wherein the intermediate layer forming step is a step of repeating applying a high frequency pulse from a high frequency power supply for plasma generation and applying a negative high voltage pulse from a power supply for high voltage pulse generation, to the base in a nitrogen gas atmosphere.

7. An electrode for electrolysis comprising:
the laminate according to any one of claims 1 to 4.

8. The electrode for electrolysis according to claim 7, the electrode is used for synthesizing a fluorine-containing compound by electrolyzing a molten salt containing a fluoride ion.

9. The electrode for electrolysis according to claim 7, the electrode is used for synthesizing fluorine gas or nitrogen trifluoride by electrolyzing a molten salt containing hydrogen fluoride.

10. A method for producing an electrode for electrolysis,
the electrode for electrolysis being the electrode for electrolysis according to any one of claims 7 to 9,
the method comprising:
an intermediate layer forming step of forming the intermediate layer by nitriding nickel of a surface layer part of the base using nitrogen gas plasma.

11. An electrolyzer, comprising:
the electrode for electrolysis according to any one of claims 7 to 9.

12. A gas production method for producing fluorine gas or nitrogen trifluoride comprising:
synthesizing fluorine gas or nitrogen trifluoride by electrolyzing a molten salt containing hydrogen fluoride using the electrode for electrolysis according to claim 7.
